# EUROPÄISCHE PATENTSCHRIFT

(11) **EP 0 453 668 B1**
(45) Veröffentlichungstag und Bekanntmachung des Hinweises auf die Patenterteilung: **23.06.1993**
(21) Anmeldenummer: 90304356.0
(22) Anmeldetag: 24.04.1990
(51) Int. Cl.: H05K 7/18

(54) **Baugruppenträger**
Electrical support
Support pour installation électrique

(43) Veröffentlichungstag der Anmeldung: 30.10.1991
(73) Patentinhaber: Rittal-Werk Rudolf Loh GmbH & Co. KG, 35745 Herborn (DE)
(72) Erfinder: Bovermann, Claus-Dieter, D-3565 Bredidenbach-Niederdieten (DE); Fursier, Roger, Longlands, Saltash, Cornwall (GB); Keens, Gary, Roborough, Plymouth (GB)
(74) Vertreter: Jeck, Anton, Dipl.-Ing.

(56) Entgegenhaltungen:
- DE-B- 2 732 139
- TECHNICAL DIGEST - WESTERN ELECTRIC. no. 68, Oktober 82, NEW YORK US Seite 19 Mc Cullough: "backplane apparatus"

## Beschreibung

Die Erfindung betrifft einen Baugruppenträger mit zwei Seitenplatten, die mit ihren Eckbereichen mittels vier Querschienen miteinander verbunden sind, und mit zwei Abdeckplatten, die die Ober- und Unterseite des Baugruppenträgers verschließen.

Bei bekannten Baugruppenträgern sind die Abdeckplatten an den Querstreben befestigt. Diese Befestigungsart ist bei Baugruppenträgern mit großem Abstand zwischen der vorderen und der zugeordneten hinteren Querschiene nicht ausreichend, da die Abdeckplatten sich schon bei geringer Belastung zwischen den Befestigungsstellen durchbiegen können. Dies kann zur Beschädigung der Kartenführungsschienen führen, die sich von der vorderen zur hinteren Querschiene erstrecken.

Es ist Aufgabe der Erfindung, einen Baugruppenträger der eingangs erwähnten Art so zu gestalten, daß die Abdeckplatten auf einfachste Weise zwischen den Querschienen zusätzlich abgestützt und befestigt werden können.

Diese Aufgabe wird nach der Erfindung dadurch gelöst, daß die horizontalen Seitenbereiche der Seitenplatten jeweils mit einer Reihe von Bohrungen mit vorgegebener Teilung versehen sind, und daß entlang dieser Seitenbereiche der Seitenplatten unter Verwendung dieser Bohrungen zwischen den jeweils zugeordneten Querschienen mindestens ein Abstützelement angebracht ist, an denen die Abdeckplatten zusätzlich befestigt und abgestützt sind.

Die Abstützelemente können zwischen der vorderen und der hinteren Querschiene an beliebigen Stellen der Seitenplatten befestigt werden und bieten neben der Abstützung der Abdeckplatten gleichzeitig eine Möglichkeit, die Abdeckplatten fest mit den Abstützelementen und damit auch den Seitenplatten zu verbinden.

Die Anbringung der Abstützelemente wird dabei dadurch vereinfacht, daß die plattenförmig ausgebildeten Abstützelemente an den den Seitenplatten zugekehrten Stirnseiten mit Fixierzapfen und einer vorzugsweise als Gewindebohrung ausgebildeten Befestigungsbohrung versehen sind, wobei der Abstand des Fixierzapfens von der Befestigungsbohrung jeweils einem ganzzahligen Vielfachen der Teilung der Bohrungen in den Seitenplatten entspricht. Pro Abstützelement wird daher nur eine einzige Befestigungsschraube benötigt.

Die Anbringung der Abdeckplatten an den Abstützelementen ist nach einer Ausgestaltung dadurch gelöst, daß die der Abdeckplatte zugekehrten Seiten der Abstützelemente mit Gewindebohrungen versehen sind und daß die den Seitenplatten zugekehrten Seitenbereiche der Abdeckplatten jeweils mit einer Reihe von Durchbrüchen versehen sind, deren Teilung vorzugsweise auf die vorgegebene Teilung der Bohrungen in den Seitenplatten abgestimmt ist. Dabei ist zudem vorgesehen, daß die Abdeckplatten mittels U-förmiger Haltefedern und Befestigungsschrauben an den Abstützelementen befestigt sind, wobei die Haltefedern die Seitenkanten der Abdeckplatten umschließen und mittels Bohrungsansätzen in den Durchbrüchen der Abdeckplatten gehalten sind.

Nach einer weiteren Ausgestaltung ist vorgesehen, daß im Bereich der Ecken der Seitenplatten Abstützelemente angebracht sind, die an den einander zugekehrten Innenseiten der Querschienen vorstehen und bei denen die den Abdeckplatten zugekehrte Gewindebohrung zum Befestigen der Abdeckplatten frei zugänglich ist. Damit lassen sich die Abdeckplatten auch mit ihren Eckbereichen mittels derselben Befestigungsart an den Seitenplatten befestigen und bieten darüber hinaus die Möglichkeit, auch die Querschienen abzustützen.

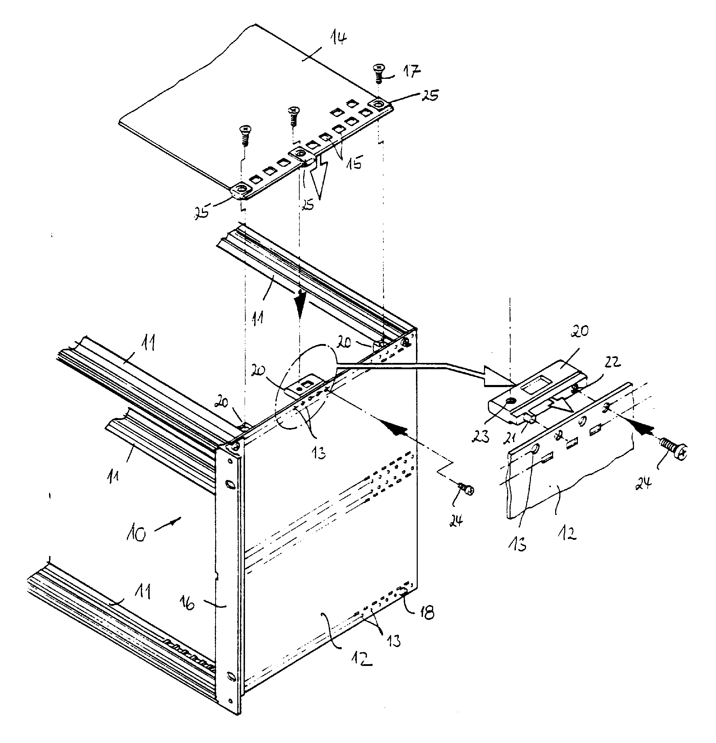

Die Erfindung wird anhand eines in der Zeichnung dargestellten Ausführungsbeispiels näher erläutert.

In der Zeichnung ist nur der rechte Teil eines Baugruppenträgers 10 gezeigt, der die vier Querschienen 11 und zwei Seitenplatten 12 aufweist. An der Vorderseite der Seitenplatten 12 sind Befestigungswinkel 16 angebracht. Die horizontalen Seitenbereiche der Seitenplatten 12 sind mit Reihen von Bohrungen 13 versehen, die in vorgegebener Teilung von z.B. 10 mm angeordnet sind. Die vier Querschienen 11 sind mit ihren Stirnseiten in bekannter Weise mit den Seitenplatten 12 verbunden. Die Kartenführungsschienen sind nicht gezeigt, da sie für die vorliegende Erfindung nicht von Bedeutung sind, ebenso die an der Rückseite angebrachten Steckeinrichtungen für die Einschübe, Leiterplatten und dgl.

Die obere und untere Seite des Baugruppenträgers 10 wird mittels Abdeckplatten 14 verschlossen, die an den Seitenbereichen, die sich von den vorderen zu den hinteren Querschienen 11 erstrecken, mit jeweils einer Reihe von Durchbrüchen 15 versehen sind, die ebenfalls in einer gleichmäßigen Teilung eingebracht sind. Diese Teilung ist auf die Teilung der Bohrungen 13 in den Seitenplatten 12 abgestimmt und beträgt ein ganzzahliges Vielfaches derselben. Die Durchbrüche 15 haben quadratischen Querschnitt und können an sich bekannte U-förmige Haltefedern 25 mit Befestigungsbohrungen aufnehmen, die auf die Seitenkanten aufschiebbar und mit Ansätzen und dgl. in die Durchbrüche 15 einrasten. Die Befestigungsschrauben 17 werden dann durch die Haltefedern 25 auf die Teilung ausgerichtet.

Wie im Ausführungsbeispiel gezeigt ist, werden plattenförmige Abstützelemente 20 verwendet, die an den Seitenplatten 12 befestigt werden. Auf einer Längskantenseite des Abstützelementes 20 ist ein Fixierzapfen 21 angeformt. Außerdem ist in diese Längskantenseite eine vorzugsweise als Gewindebohrung ausgebildete Befestigungsbohrung 22 eingebracht. Der Abstand zwischen dem Fixierzapfen 21 und der Befestigungsbohrung 22 beträgt ein Vielfaches der Teilung der Bohrungen 13 in den Seitenplatten 12. Auf diese Weise kann das Abstützelement 20 mittels einer einzigen Befestigungsschraube 24 unverdrehbar an der Seitenplatte 12 festgelegt werden. Der Abstand der Reihe von Bohrungen 13 von der Seitenkante definiert dabei die Lage der Auflage- und Befestigungsfläche des Abstützelementes 20 für die Abdeckplatte 14 am Baugruppenträger 10. Die der Abdeckplatte 14 zugekehrte Seite der Abstützelemente 20 hat eine Gewindebohrung 23 zum Einschrauben der Befestigungsschraube 17, mit der die Abdeckplatte 14 am Abstützelement 20 befestigt wird. Die Gewindebohrung 23 ist auf den Fixierzapfen 21 ausgerichtet, um die Abdeckplatte 14 mit der Reihe von Durchbrüchen 15 auf die Teilung der Bohrungen 13 in den Seitenplatten 12 auszurichten.

Durch die Teilung der Bohrungen 13 werden die Stellungen vorgegeben, an denen Abstützelemente 20 mit den Seitenplatten 12 verbunden werden können. Dabei können zwischen den Querschienen 11 ein einziges Abstützelement 20 oder mehrere Abstützelemente 20 an den Seitenplatten 12 angebracht und die Abdeckplatten an einer Stelle oder mehreren Stellen abgestützt und mit den Seitenplatten 12 verbunden werden.

Wie im Ausführungsbeispiel gezeigt ist, können die Abstützelemente 20 auch zur Abstützung der Querschienen 11 verwendet werden. Es ist dann nur dafür Sorge zu tragen, daß die Abstützelemente 20 an der vorderen und hinteren Querschiene 11 nach innen vorstehen und in den vorstehenden Bereichen eine Gewindebohrung zum Anbringen der Abdeckplatte 14 aufweisen. Dabei werden Abstützelemente 20 und zwei Gewindebohrungen 23 verwendet, die in demselben Abstand wie der Fixierzapfen 21 und die Befestigungsbohrung 22 angeordnet sind und auf diese ausgerichtet sind. Es lassen sieh dann identische Abstützelemente 20 zum Anbringen der unteren und der oberen Abdeckplatte 14 an der linken oder der rechten Seitenplatte 12 des Baugruppenträgers 210 verwenden.

## Patentansprüche

1. Baugruppenträger (10) mit zwei Seitenplatten (12), die mit ihren Eckbereichen mittels vier Querschienen (11) miteinander verbunden sind, und mit zwei Abdeckplatten (14), die die Ober- und Unterseite des Baugruppenträgers (10) verschließen,
dadurch gekennzeichnet,
daß die horizontalen Seitenbereiche der Seitenplatten (12) jeweils mit einer Reihe von Bohrungen (13) mit vorgegebener Teilung versehen sind, und
daß entlang dieser Seitenbereiche der Seitenplatten (12) unter Verwendung dieser Bohrungen (13) zwischen den jeweils zugeordneten Querschienen (11) mindestens ein Abstützelement (20) angebracht ist, an denen die Abdeckplatten (14) zusätzlich befestigt und abgestützt sind.

2. Baugruppenträger nach Anspruch 1,
dadurch gekennzeichnet,
daß die plattenförmig ausgebildeten Abstützelemente (20) an den den Seitenplatten (12) zugekehrten Stirnseiten mit Fixierzapfen (21) und einer vorzugsweise als Gewindebohrung ausgebildeten Befestigungsbohrung (22) versehen sind, wobei der Abstand des Fixierzapfens (21) von der Befestigungsbohrung (22) jeweils einem ganzzahligen Vielfachen der Teilung der Bohrungen (13) in den Seitenplatten (12) entspricht.

3. Baugruppenträger nach Anspruch 1 oder 2,
dadurch gekennzeichnet,
daß die der Abdeckplatte (14) zugekehrten Seiten der Abstützelemente (20) mit Gewindebohrungen (23) versehen sind und
daß die den Seitenplatten (12) zugekehrten Seitenbereiche der Abdeckplatten (14) jeweils mit einer Reihe von Durchbrüchen (15) versehen sind, deren Teilung vorzugsweise auf die vorgegebene Teilung der Bohrungen (13) in den Seitenplatten (12) abgestimmt ist.

4. Baugruppenträger nach Anspruch 3,
dadurch gekennzeichnet,
daß die Abdeckplatten (14) mittels U-förmiger Haltefedern (25) und Befestigungsschrauben (17) an den Abstützelementen (20) befestigt sind, wobei die Haltefedern (25) die Seitenkanten der Abdeckplatten (14) umschließen und mittels Bohrungsansätzen in den Durchbrüchen (15) der Abdeckplatten (14) gehalten sind.

5. Baugruppenträger nach einem der Ansprüche 1 bis 4,
dadurch gekennzeichnet,
daß im Bereich der Ecken der Seitenplatten (12) Abstützelemente (20) angebracht sind, die an den einander zugekehrten Innenseiten der Querschienen (11) vorstehen und bei denen die den Abdeckplatten (14) zugekehrte Gewindebohrung (23) zum Befestigen der Abdeckplatten (12) frei zugänglich ist.

## Claims

1. Support for components (10), including two lateral panels (12) which are interconnected at their corner regions by means of four transverse crossbars (11), and two cover plates (14) which close the upper and lower ends of the support (10), characterised in that the horizontal lateral regions of the lateral panels (12) are each provided with a line of bores (13) having prescribed spacings therebetween, and in that at least one support member (20) is fitted, by employing these bores (13), along the lateral regions of the lateral panels (12) between the respectively associated transverse crossbars (11), the cover plates (14) being additionally mounted and supported on said support members.

2. Support according to claim 1, characterised in that a securing pin (21) and a mounting bore (22), which is preferably a threaded bore, are provided on the end faces of the plate-shaped support members (20) facing the lateral panels (12), each spacing between the securing pin (21) and the mounting bore (22) corresponding to an integer multiple of the spacing between the bores (13) in the lateral panels (12).

3. Support according to claim 1 or 2, characterised in that the ends of the support members (20) facing the cover plate (14) are provided with threaded bores (23), and in that the lateral regions of the cover plates (14) facing the lateral panels (12) are each provided with a line of openings (15), the spacings therebetween preferably being adapted to the prescribed spacing between the bores (13) in the lateral panels (12).

4. Support according to claim 3, characterised in that the cover plates (14) are mounted on the support members (20) by means of U-shaped retaining springs (25) and mounting screws (17), the retaining springs (25) surrounding the lateral edges of the cover plates (14) and being retained in the openings (15) in the cover plates (14) by means of bore extension members.

5. Support according to one of claims 1 to 4, characterised in that support members (20) are fitted in the region of the corners of the lateral panels (12) and protrude beyond the internal surfaces of the transverse crossbars (11) facing one another, the threaded bore (23) facing the cover plates (14) being freely accessible for the mounting of the cover plates (14).

## Revendications

1. Support pour installations électriques (10) avec deux plaques latérales (12) qui par leurs zones d'angle sont reliées l'une à l'autre au moyen de quatre rails transversaux (11) et avec deux plaques de recouvrement (14) qui scellent la face supérieure et la face inférieure du support (10),
caractérisé
par le fait que les régions latérales horizontales des plaques latérales (12) présentent chacune une série de forures (13) écartées les unes des autres d'une distance prédéterminée, et
par le fait que le long de ces régions latérales des plaques latérales (12) il est fixé, avec emploi de ces forures (13), entre les rails transversaux (11) y associés, au moins un élément d'étayage (20), sur lequel ou sur lesquels les plaques de recouvrement (14) trouvent une fixation et un étayage supplémentaires.

2. Support pour installations électriques suivant la revendication 1,
caractérisé
par le fait que les éléments d'étayage (20) en forme de plaque présentent sur les faces frontales en regard des plaques latérales (12) des tourillons de fixation (21) et une forure de fixation (22) ayant de préférence la forme d'une forure filetée, la distance entre le tourillon de fixation (21) et la forure de fixation (22) correspondant à un multiple entier de la distance entre les forures (13) dans les plaques latérales (12).

3. Support pour installations électriques suivant l'une ou l'autre des revendications 1 et 2
caractérisé
par le fait que les côtés des éléments d'étayage (20) en regard de la plaque de recouvrement (14) présentent des forures filetées (23) et
par le fait que les régions latérales des plaques de recouvrement (14) en regard des plaques latérales (12) présentent chacune une série de passages (15) dont la distance mutuelle est de préférence harmonisée avec la distance prédéterminée des forures (13) dans les plaques latérales (12).

4. Support pour installations électriques suivant la revendication 3,
caractérisé
par le fait que les plaques de recouvrement (14) sont au moyen de ressorts de fixation en forme de U (25) et de vis de fixation (17) fixés aux éléments d'étayage (20), les ressorts de fixatyion (25) enserrant les arêtes latérales des plaques de recouvrement (14) et étant maintenus dans les passages (15) des plaques de recouvrement (14) au moyen d'épaulements de forure.

5. Support pour installations électriques suivant l'une quelconque des revendications de 1 à 4
caractérisé
par le fait que dans la région des angles des plaques latérales (12) sont disposés des éléments d'étayage (20), qui font protubérance sur les côtés intérieurs de faisant face des rails transversaux (11) et dont le forage fileté (23) faisant face aux plaques de recouvrement (14) est accessible aux fins de la fixation des plaques de recouvrement (12)
